# EUROPEAN PATENT APPLICATION

(11) **EP 2 645 560 A1**
(43) Date of publication of application: **02.10.2013**
(21) Application number: 13161653.4
(22) Date of filing: 28.03.2013
(51) Int. Cl.: H02N 2/00, H02N 2/10, H02N 2/02, H01L 41/09

(54) **Piezoelectric motor**

(30) Priority: 29.03.2012 JP 2012076462
(71) Applicant: Seiko Epson Corporation, Tokyo 163-0811 (JP)
(72) Inventor: Mizushima, Nobuyuki, Nagano 392-8502 (JP); Kamijo, Koichi, Nagano 392-8502 (JP)
(74) Representative: HOFFMANN EITLE

(57) **Abstract**

A piezoelectric motor (10) includes a first supporting member (30), a second supporting member (31), a third supporting member (32), and a fourth supporting member (33) configured to support a piezoelectric element (20), and the respective supporting members are formed with irregularities (T) on contact surfaces thereof. In this configuration, the contact surfaces are prevented from being displaced, and reliable holding of the piezoelectric element (20) and prevention of drive energy loss of a driven member (90) are achieved.

## Description

### BACKGROUND

### 1. Technical Field

The present invention relates to a piezoelectric motor, a robot hand, and a robot.

### 2. Related art

In the related art, a piezoelectric motor (piezoelectric actuator) configured to cause a driven member to rotate or to make a linear motion by using in-plane vibrations of a flat-plate piezoelectric element is known. As an example of such a piezoelectric motor, there is disclosed a structure configured to hold a piezoelectric element by urging a side surface position which corresponds to a vibration node thereof by a resilient member in a certain direction in JP-A-8-237971.

However, the piezoelectric motor disclosed in JP-A-8-237971 has a problem that the arrangement of the resilient member that holds the piezoelectric element so as to limit the direction of vibration of the piezoelectric element, in particular, bending vibration causes deterioration of the resilient member with time due to the vibrations of the piezoelectric element, and loss of driving energy of a driven member.

### SUMMARY

It is the object underlying the present invention to solve at least a part of the problems described above.

In order to achieve this object, the present invention provides, on the one hand, a piezoelectric motor including the features of claim 1.

In this configuration, since the first main surface supporting member and the second main surfaces supporting member are formed with the irregularities on the contact surfaces therebetween and are joined with the piezoelectric element by the joint material, the joint surfaces are prevented from being displaced with time, and reliable holding of the piezoelectric element and prevention of drive energy loss of the driven member are achieved.

It is preferable that the contact surfaces of the first main surface holding member and the second main surface holding member are formed with the irregularities, and the contact surfaces of the piezoelectric element are also formed with the irregularities.

In this configuration, a frictional force on the contact surface of the piezoelectric element with respect to the first main surface supporting member and the second main surface supporting member is further enhanced, and hence the piezoelectric element is held further reliably, whereby prevention of drive energy loss of the driven member is achieved.

The present invention also provides a robot hand including such a piezoelectric motor as a drive unit.

In this configuration, in the drive unit, since the first main surface supporting member and the second main surface supporting member are formed with the irregularities on the contact surface therebetween and are joined with the piezoelectric element by the joint material, the joint surfaces are prevented from being displaced with time, and prevention of drive energy loss of the driven member is achieved.

Accordingly, a robot hand which resists lowering of drive energy even when being used for a long time may be provided.

The present invention also provides a robot including such a piezoelectric motor as a drive unit.

In this configuration, in the drive unit, since the first main surface supporting member and the second main surfaces supporting member are formed with the irregularities on the contact surface therebetween and are joined with the piezoelectric element by the joint material, the joint surfaces are prevented from being displaced with time, and prevention of drive energy loss of the driven member is achieved.

Accordingly, a robot which resists lowering of drive energy even when being used for a long time may be provided.

In order to achieve the above object, on the other hand, the present invention provides a piezoelectric motor including the features of claim 5, and a robot hand and a robot including such a piezoelectric motor,

### BRIEF DESCRIPTION OF THE DRAWINGS

The invention will be described with reference to the accompanying drawings, wherein like numbers reference like elements.

Fig. 1 is a plan view illustrating a piezoelectric motor.

Fig. 2 is a cross-sectional view illustrating a cross-sectional plane along D-D in Fig. 1.

Fig. 3A is a schematic plan view illustrating a configuration and a driving method of a piezoelectric element in a standstill state.

Fig. 3B is a schematic view illustrating vibrations of the piezoelectric element and a method of driving a driven member.

Fig. 3C a schematic view illustrating vibrations of the piezoelectric element and the method of driving the driven member.

Fig. 3D is a schematic view illustrating vibrations of Figs. 3B and 3C in a combined state.

Fig. 4 is a plan view showing a relationship of supporting portions S1 S2, S3, and S4 with respect to the piezoelectric element and a supporting member.

Fig. 5 is a cross-sectional view schematically illustrating a pressure-supporting structure of the piezoelectric element.

Fig. 6A is a schematic view illustrating part of the piezoelectric motor of a first embodiment in a state before being pressed.

Fig. 6B illustrates a schematic cross section of part of the piezoelectric motor in a state of being pressed.

Fig. 6C illustrates a schematic cross section and a plan view of an example of irregularities.

Fig. 7A is a schematic view illustrating part of the piezoelectric motor of a second embodiment in a state before being pressed.

Fig. 7B is a schematic view of the part of the piezoelectric motor illustrating an example of the irregularities.

Fig. 7C is a schematic view of the part of the piezoelectric motor illustrating a cross section thereof in a state of being pressed.

Fig. 8 is an explanatory drawing illustrating a robot hand having the piezoelectric motor of the second embodiment integrated therein.

Fig. 9 is an explanatory drawing illustrating a. single-arm robot having the robot hand.

Fig. 10 is an explanatory drawing illustrating a plural-arm robot having the robot hand.

### DESCRIPTION OF EXEMPLARY EMBODIMENTS

Referring now to the drawings, embodiments of the invention will be described. In the drawings given below, scales of respective layers and members are differentiated from actual scales in order to make the respective layers and members recognizable in the drawing.

### Piezoelectric Motor

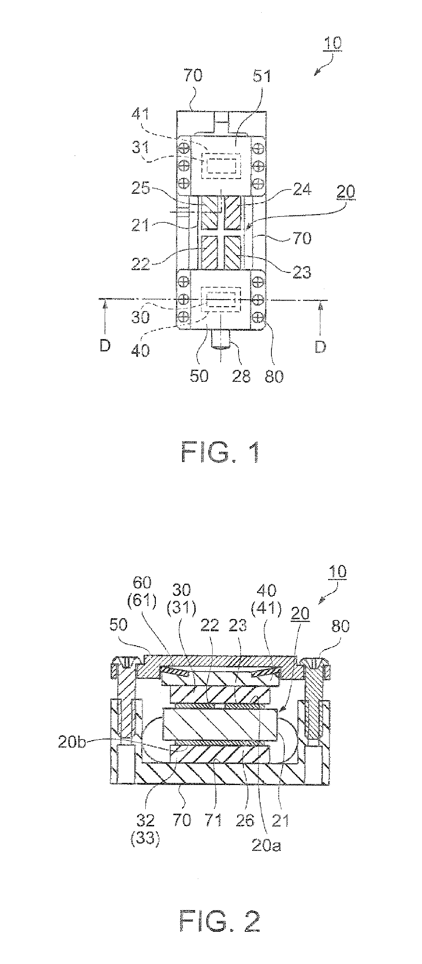

Fig. 1 is a plan view illustrating a piezoelectric motor 10, and Fig. 2 is a cross-sectional view illustrating a cross-sectional plane along D-D in Fig. 1. In Fig. 1 and Fig. 2, the piezoelectric motor 10 includes a piezoelectric element 20 having a rectangular flat surface and configured to drive a driven member by in-plane vibrations, and a first supporting member 30 and a second supporting member 31 configured to come into abutment on respective supporting portions arranged separately in four corner directions of a first main surface 20a of the piezoelectric element 20. The first supporting member 30 and the second supporting member 31 correspond to first main surface supporting members.

The piezoelectric motor 10 includes holding members including a first holding plate 40 configured to press the first supporting member 30 and a second holding plate 41 configured to press the second supporting member 31, a third supporting member 32 coming into abutment with a second main surface 20b facing the first main surface 20a of the piezoelectric element 20 disposed at a position surface-symmetrical with the first supporting member 30 with the piezoelectric element 20 interposed therein, and a fourth supporting member 33 disposed at a position surface-symmetrical with the second supporting member 31. The third supporting member 32 and the fourth supporting member 33 correspond to second main surface supporting members. A case 70 as a machine casing member configured to press the second main surface supporting members against the piezoelectric element 20 is further provided.

The piezoelectric motor 10 is also provided with a first holding spring 60 and a second holding spring 61 as resilient members configured to press the second main surface supporting members (the third supporting member 32 and the fourth supporting member 33), the piezoelectric element 20, the first main surface supporting members (the first supporting member 30 and the second supporting member 31), and the holding members (the first holding plate 40 and the second holding plate 41) stacked one on top of another on a case bottom surface 71 of the case 70 in this order at positions of the supporting portions.

The first holding spring 60 is sandwiched between the first holding plate 40 and a first fixing plate 50, and is configured to press the first supporting member 30 and the third supporting member 32 against the piezoelectric element 20 by tightening a fixing screw 80 to the case 70.

The second holding spring 62 is sandwiched between the second holding plate 41 and a second fixing plate 51, and is configured to press the second supporting member 31 and the fourth supporting member 33 against the piezoelectric element 20 by tightening the fixing screw 80 to the case 70. Fig. 2 illustrates an initial state in which the first holding spring 60 and the second holding spring 61 do not press the supporting members.

In this case, as illustrated in Fig. 2, the first fixing plate 50 and the second fixing plate 51 have a gap with respect to the case 70 in the thickness direction. The gap is provided for absorbing variations in thickness of the piezoelectric element 20, the first main surface supporting member, the second main surface supporting member, the first holding plate 40, and the second holding plate 41 by the first holding spring 60 and the second holding spring 61 when these components are stacked one on top of another. In this embodiment, pressing forces of the first holding spring 60 and the second holding spring 61 are approximately several kilograms.

The piezoelectric element 20 is provided with a projecting portion 28 at an end portion on the short side thereof. The projecting portion 28 comes into contact with a driven member, and is configured to drive the driven member by a frictional force thereof, so that a material having a high coefficient of friction with respect to the driven member and superior in abrasion resistance is used. For example, hard materials such as zirconia and ceramics are used. The projecting portion 28 makes an ellipsoidal motion by bending vibrations of the piezoelectric element 20 and drives the driven member.

Subsequently, the piezoelectric element 20 used for the piezoelectric motor 10 and a method of driving the same of this embodiment will be described.

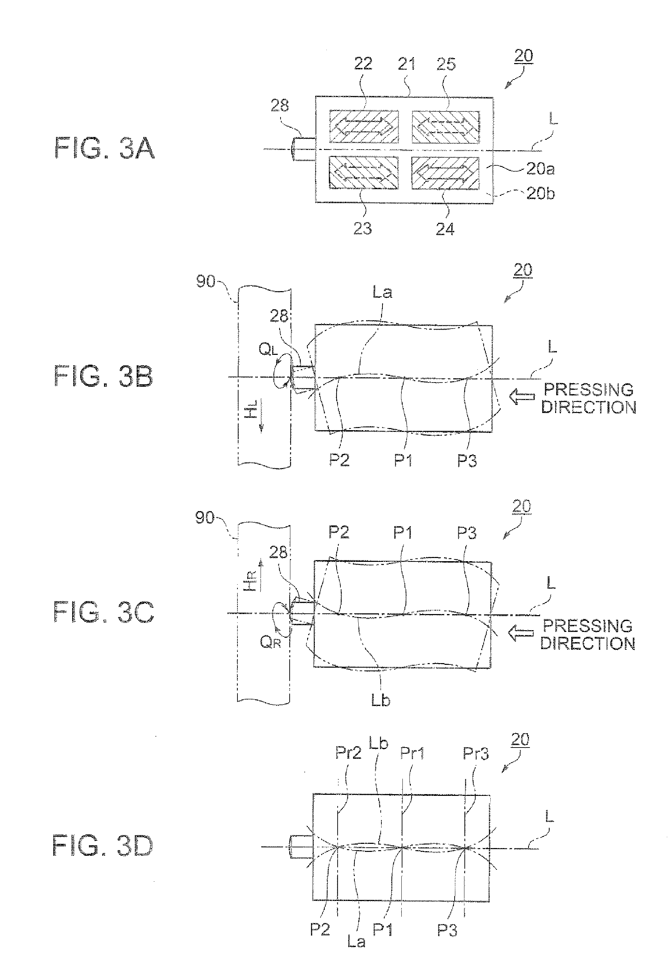

Fig. 3A is a schematic plan view illustrating a configuration and a driving method of the piezoelectric element 20 in a standstill state. Fig. 3B is a schematic view illustrating vibrations of the piezoelectric element 20 and the method of driving the driven member. Fig. 3C a schematic view illustrating vibrations of the piezoelectric element 20 and the method of driving the driven member. Fig. 3D is a schematic view illustrating vibrations of Figs. 3B and 3C in a combined state.

In Fig. 3A, the piezoelectric element 20 is formed with a first excitation electrode 22, a second excitation electrode 23, a third excitation electrode 24, and a fourth excitation electrode 25 on the side of the first main surface 20a of a piezoelectric body 21. Also, a common electrode 26 (see Fig. 2) is formed substantially over the entire surface of the piezoelectric body 21 on the second main surface 20b side, which has a front and back relationship with respect to the first main surface 20a.

The material of the piezoelectric body 21 is not limited specifically as long as the material has piezoelectric properties. However, PZT (lead zirconate titanate) is preferably used. The materials of the first excitation electrode 22, the second excitation electrode 23, the third excitation electrode 24, the fourth excitation electrode 25, and the common electrode 26 are not specifically limited as long as being metals having conductivity. However, a method of forming Ag paste by screen printing or the like, or methods of forming Al, Au, W, Cu, and Ag by spattering or vapor-deposition technique are applicable.

The first excitation electrode 22 and the third excitation electrode 24 are electrically connected and the second excitation electrode 23 and the fourth excitation electrode 25 are electrically connected. According to an electrode configuration as described above, vertical vibrations in which the piezoelectric body 21 is elongated (as indicated by arrows of solid lines) when an electric charge is applied to the first excitation electrode 22 and the third excitation electrode 24, and is restored when the electric charge is removed are excited. In contrast, vertical vibrations in which the piezoelectric body 21 is elongated (as indicated by arrows of broken lines) when an electric charge is applied to the second excitation electrode 23 and the fourth excitation electrode 25, and is restored when the electric charge is removed are excited.

In this manner, by the application of the electric charge to the first excitation electrode 22 and the third excitation electrode 24 or to the second excitation electrode 23 and the fourth excitation electrode 25, in-plane bending vibrations are excited in the piezoelectric element 20. Referring now to Figs. 3B, 3C, and 3D, the bending vibrations excited in this manner will be described.

Fig. 3B illustrates a case where the electric charge is applied between the first excitation electrode 22 and the third excitation electrode 24, and the common electrode 26, and no electric charge is applied to the second excitation electrode 23 and the fourth excitation electrode 25, in which the vertical vibrations are excited in a range where the first excitation electrode 22 and the third excitation electrode 24 are formed (see Fig 3A). However, since no electric charge is applied to the second excitation electrode 23 and the fourth excitation electrode 25, the vertical vibrations are not excited. Consequently, the piezoelectric element 20 excites secondary bending vibrations in a plane as illustrated in Fig. 3B, and the projecting portion 28 makes an ellipsoidal motion in the direction of arrows of an illustrated ellipsoidal trajectory Q_{L}. The projecting portion 28 is pressed against a driven member 90, and hence moves the driven member 90 in abutment thereto in an H_{L} direction by the ellipsoidal trajectory in the direction Q_{L} of the projecting portion 28.

As illustrated in Fig. 3B, L indicates a center axis of the bending vibrations, P1, P2, and P3 indicate vibration nodes, and La indicates a vibration mode.

In a contact portion between the projecting portion 28 and the driven member 90, a drive force is generated by a frictional force of the contact portion with respect to the driven member 90 by the ellipsoidal trajectory Q_{L} of the projecting portion 28. With this driving force, the driven member 90 is driven in the H_{L} direction.

Fig. 3C illustrates a case where the electric charge is applied between the second excitation electrode 23 and the fourth excitation electrode 25, and the common electrode 26, and no electric charge is applied to the first excitation electrode 22 and the third excitation electrode 24, in which the vertical vibrations are excited in a range where the second excitation electrode 23 and the fourth excitation electrode 25 are formed (see Fig. 3A) . However, since no electric charge is applied to the first excitation electrode 22 and the third excitation electrode 24, the vertical vibrations are not excited. Consequently, the piezoelectric element 20 excites the secondary bending vibrations in the plane as illustrated in Fig. 3C, and the projecting portion 28 makes an ellipsoidal motion in the direction of arrows of an illustrated ellipsoidal trajectory Q_{R}. The projecting portion 28 is pressed against the driven member 90, and hence drives the driven member 90 in an H_{R} direction by the ellipsoidal movement in the direction Q_{R} of the projecting portion 28.

As illustrated in Fig. 3C, L indicates the center axis of the bending vibrations, P1, P2, and P3 indicate the vibration nodes, and Lb indicates a vibration mode.

In the contact portion between the projecting portion 28 and the driven member 90, a drive force is generated by a frictional force of the contact portion with respect to the driven member 90 by the ellipsoidal trajectory Q_{R} of the projecting portion 28. With this driving force, the driven member 90 is driven in the H_{R} direction.

In this manner, by switching the application of the electric charge to the first excitation electrode 22 and the third excitation electrode 24, and to the second excitation electrode 23 and the fourth excitation electrode 25, the direction of the bending vibrations of the piezoelectric element 20 is changed, so that the direction of driving of the driven member 90 may be switched easily.

The nodes of the vibrations in the two vibration modes; the bending vibrations and the vertical vibrations of the piezoelectric element 20 as described above; will be described with reference to Fig. 3D.

Fig. 3D illustrates a conceptual drawing illustrating the vibration modes of the piezoelectric element 20. As illustrated in Fig. 3D, the piezoelectric element 20 is illustrated to be in a bending vibration mode of the vibrating states described by using Fig. 3B and Fig. 3C. When showing combined vibration modes La and Lb, there exist the vibration nodes P1, P2, and P3 on the center axis L of the vibrations.

A range overlapped on lines Pr1, Pr2, and Pr3 passing through the vibration nodes P1, P2, and P3 and being extended in the direction orthogonal to the vertical vibrations of the piezoelectric element 20 (hereinafter, referred to as the node lines Pr1, Pr2, and Pr3) is an area in which displacement of the piezoelectric element 20 is smaller than other areas. Therefore, it is preferable that the supporting portions that pressure-support the piezoelectric element 20 are arranged in an range overlapped on the node lines Pr1, Pr2, and Pr3 and, it is more preferable that the supporting portions are arranged in an area including the vibration nodes P2 and P3 which are closest to an outline portion of the piezoelectric element 20.

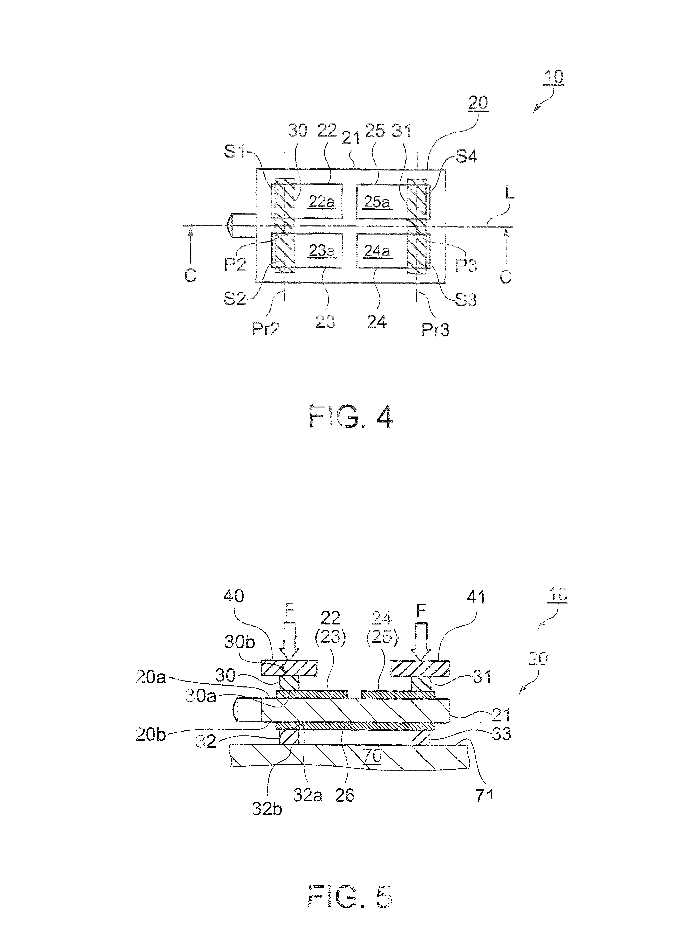

Subsequently, the pressure supporting structure of the piezoelectric element 20 will be described with reference to Fig. 4 and Fig. 5.

Fig. 4 is a plan view illustrating a relationship of supporting portions S1, S2, S3, and S4 of the piezoelectric element 20 with respect to a supporting member. Here, the first supporting member 30 is arranged on a node line Pr2 so as to extend across the first excitation electrode 22 and the second excitation electrode 23. An area in which the first supporting member 30 and the first excitation electrode 22 intersect is a supporting portion S1, and an area in which the first supporting member 30 and the second excitation electrode 23 intersect is a supporting portion S2. The third supporting member 32 is arranged so as to be substantially plane symmetrical with the first supporting member 30 with the piezoelectric element 20 interposed therebetween (see Fig. 5) .

In contrast, the second supporting member 31 is arranged on the node line Pr3 so as to extend across the third excitation electrode 24 and the fourth excitation electrode 25. An area in which the second supporting member 31 and the third excitation electrode 24 intersect is a third supporting portion S3 and an area in which the second supporting member 31 and the fourth excitation electrode 25 intersect is a supporting portion S4. The fourth supporting member 33 is arranged so as to be substantially plane symmetrical with the second supporting member 31 with the piezoelectric element 20 interposed therebetween.

As described above, the supporting portions S1, S2, S3, and S4 are respectively arranged in the four corner directions of the piezoelectric element 20.

The piezoelectric element 20 of this embodiment has a flat-parallelepiped shape having a length of 30 mm, a width of 7.5 mm, and a thickness of 3.0 mm, and reduction in size and weight of the piezoelectric motor 10 are enabled in comparison with other motors such as a step motor or a servo motor.

Fig. 5 is a cross-sectional view schematically illustrating the pressure-supporting structure of the piezoelectric element 20, and shows a cross-sectional plane along C-C in Fig. 4. As illustrated in Fig. 5, the piezoelectric element 20 is pressure-supported by a pressing force F by the first holding spring 60 and the second holding spring 61 (not illustrated) at the positions of the supporting portions S1, S2, S3, and S4 (see Fig. 4) in a state in which the third supporting member 32 and the fourth supporting member 33 are disposed on the case bottom surface 71, then the piezoelectric element 20 is stacked on the top of the third supporting member 32 and the fourth supporting member 33, the first supporting member 30 and the second supporting member 31 are stacked on the top of the piezoelectric element 20, and then the first holding plate 40 and the second holding plate 41 are stacked.

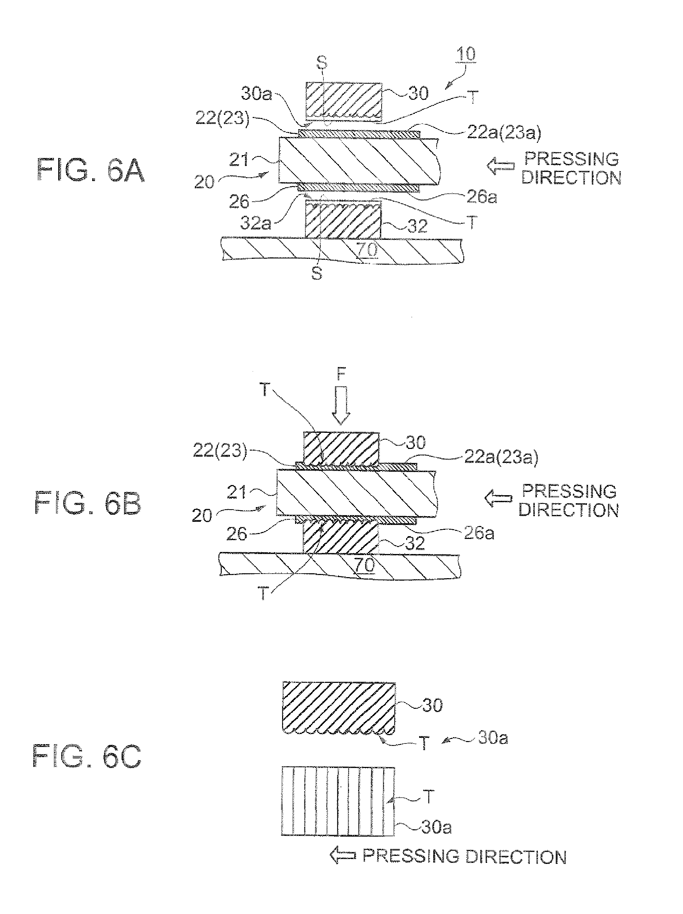

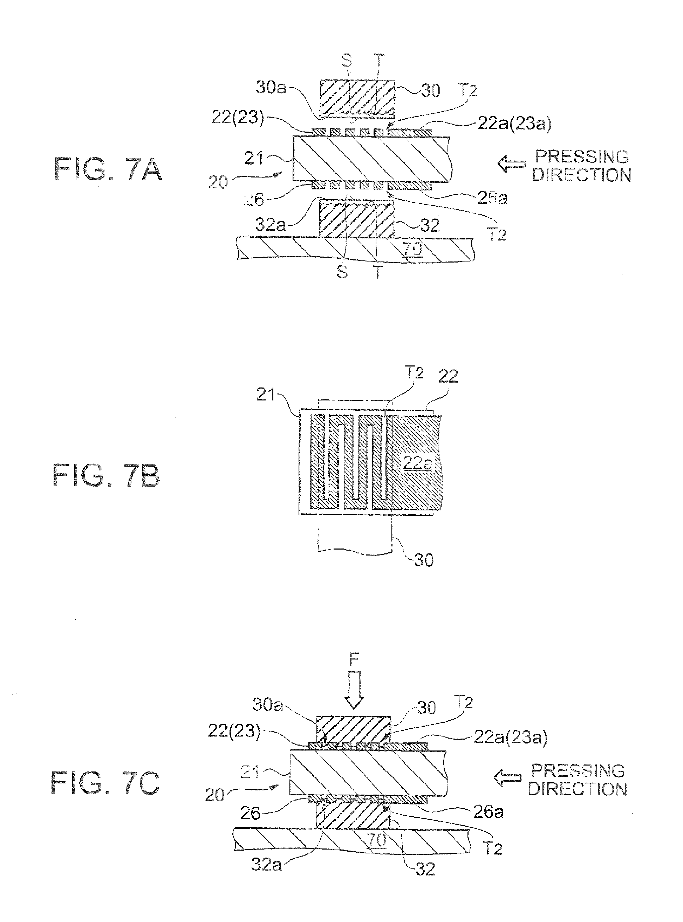

More specifically, as illustrated in Fig. 4 and Fig. 5, the first supporting member 30 is in surface contact with a surface 22a of the first excitation electrode 22 and a surface 23a of the second excitation electrode 23, and the second supporting member 31 is in surface contact with a surface 24a of the third excitation electrode 24 and a surface 25a of the fourth excitation electrode 25. The third supporting member 32 and the fourth supporting member 33 are in surface contact with a surface 26a of the common electrode 26. In the pressure support of the piezoelectric element 20, a frictional force is preferably increased by interposing a joint material on contact surfaces of the respective elements described above, and forming irregularities thereon. The configuration of the contact surfaces of the respective components described above will be described with reference to an embodiment in Figs. 6 and 7.

### First Embodiment

Fig. 6A is a schematic view illustrating a piezoelectric motor of a first embodiment in a state before the respective components are joined, and Fig. 6B is a schematic cross-sectional view illustrating part of the piezoelectric motor in a state in which the respective components are joined. The first embodiment shows a configuration in which contact surfaces of the first supporting member 30, the second supporting member 31, the third supporting member 32, and the fourth supporting member 33 with respect to the piezoelectric element 20 are formed with irregularities T. Also, Fig. 6C exemplifies the shape of the irregularities T. The first supporting member 30, the second supporting member 31, the third supporting member 32, and the fourth supporting member 33 have substantially common specifications. Therefore, the first supporting member 30 and the third supporting member 32 facing the first supporting member 30 will be described as examples.

As illustrated in Fig. 6A, a surface 30a of the first supporting member 30 on the side coming into contact with the piezoelectric element 20 and a surface 32a of the third supporting member 32 on the side of the piezoelectric element 20 are formed with the irregularities T. In the first embodiment, the first supporting member 30, the second supporting member 31, the third supporting member 32, and the fourth supporting member 33 are formed of a material such as polyimide or an ABS resin, and are formed into a parallelepiped having a length of 5.0 mm, a width of 6.5 mm, and a thickness of 1.0 mm. Also, the first excitation electrode 22, the second excitation electrode 23, the third excitation electrode 24, the fourth excitation electrode 25, and the common electrode 26 are formed of Ag paste.

Subsequently, when a joint material S is applied between the excitation electrodes 22 and 23 and the first supporting member 30 and between the common electrode 26 and the third supporting member 32, the joint material S runs over the entire surfaces of the irregularities T of the third supporting member 32, and these members are joined as illustrated in Fig. 6B. In Fig. 6B, the joint material S is omitted. As a material of the joint material S, for example, acrylic adhesive agent or the like is used. The acrylic adhesive agent is resistant to strength deterioration due to a temperature change.

In this manner, by the presence of a joint force of the joint material S and the irregularities T of the first supporting member 30 and the third supporting member 32, increase of the frictional force of the contact surfaces is achieved. Since the irregularities T may be of various forms, a representative embodiment will be described as an example.

Fig. 6C illustrates an example in which the irregularities T are formed linearly, and an upper drawing is a cross-sectional view, and a lower drawing is a plan view. The irregularities T are formed linearly in the direction substantially orthogonal to the direction of vertical vibrations of the piezoelectric element 20. The irregularities T are formed by using a file, a sanding sheet, a hard transfer die, or the like. The pitch and the depth of the irregularities T are determined by the surface hardness of the respective electrodes as counterparts.

As described thus far, according to the piezoelectric motor 10 of the first embodiment, the following effects are achieved.

The piezoelectric motor 10 described above is formed with the irregularities T on the respective contact surfaces of the first supporting portion S1, the second supporting portion S2, the third supporting portion S3, and the fourth supporting portion S4. In this configuration, the joint surfaces are prevented from being displaced with time, and reliable holding of the piezoelectric element 20 and prevention of drive energy loss of the driven member 90 are achieved.

The irregularities may be formed on the respective electrodes, which will be described as a second embodiment with reference to Figs. 7A to 7C.

### Second Embodiment

Fig. 7A is a schematic view illustrating part of the second embodiment in a state before being joined, Fig. 7B is a schematic view illustrating an example of the irregularities, and Fig. 7C is a schematic view illustrating a cross section of a state of being joined. The second embodiment has a configuration in which the respective supporting members and the first excitation electrode 22, the second excitation electrode 23, the third excitation electrode 24, and the fourth excitation electrode 25 and the common electrode 26 formed on the piezoelectric element 20 are formed with the irregularities. The first supporting member 30 and the first excitation electrode 22, and the third supporting member 32 and the common electrode 26 will be described as an example. The common components to the first embodiment (see Figs. 6A to 6C) are designated by the same reference signs.

As illustrated in Fig. 7A, the first supporting member 30 and the third supporting member 32 are formed with the irregularities T, and the first excitation electrode 22 and the common electrode 26 are formed with irregularities T2.

The irregularities T2 are formed by patterning the first excitation electrode 22 in an area where the first supporting member 30 and the first excitation electrode 22 intersect, that is, in an area of the first supporting portion S1. The same applies to the common electrode 26. The irregularities T2 may be formed into a desired shape easily by screen printing, and the width and the pitch of parts corresponding to convex portions or depressed portions are determined by the surface hardness of the electrode material and the supporting material.

Then, when the joint material S is applied between the excitation electrodes 22 and 23 and the first supporting member 30 and between the common electrode 26 and the third supporting member 32, the joint material S runs along the entire surfaces of the first supporting member 30, the irregularities T of the third supporting member 32, and the irregularities T2 of the respective electrodes, and these members are joined as illustrated in Fig. 7C. In Fig. 7C, the joint material S is omitted.

In this manner, by the presence of the joint force of the joint material S and the irregularities T of the first supporting member 30 and the third supporting member 32, and the irregularities T2 of the respective electrodes increase of the frictional force of the contact surfaces is achieved. The shapes of the irregularities T2 on the side of the excitation electrode and the shapes of the irregularities T2 on the side of the common electrode do not necessarily have to be the same.

As described thus far, according to the piezoelectric motor 10 of the second embodiment, the following effects are achieved.

The piezoelectric motor 10 described above is formed with the irregularities T on the respective contact surfaces of the first supporting portion S1, the second supporting portion S2, the third supporting portion S3, and the fourth supporting portion S4, and the first excitation electrode 22, the second excitation electrode 23, the third excitation electrode 24, and the fourth excitation electrode 25 and the common electrode 26 are formed with the irregularities T2. In this configuration, the frictional force is further enhanced, the joint surfaces are prevented from being displaced with time, and reliable holding of the piezoelectric element 20 and prevention of drive energy loss of the driven member 90 are achieved.

### Third Embodiment

The piezoelectric motor 10 of the embodiments described above may be preferably integrated as a drive unit configured to drive a robot hand.

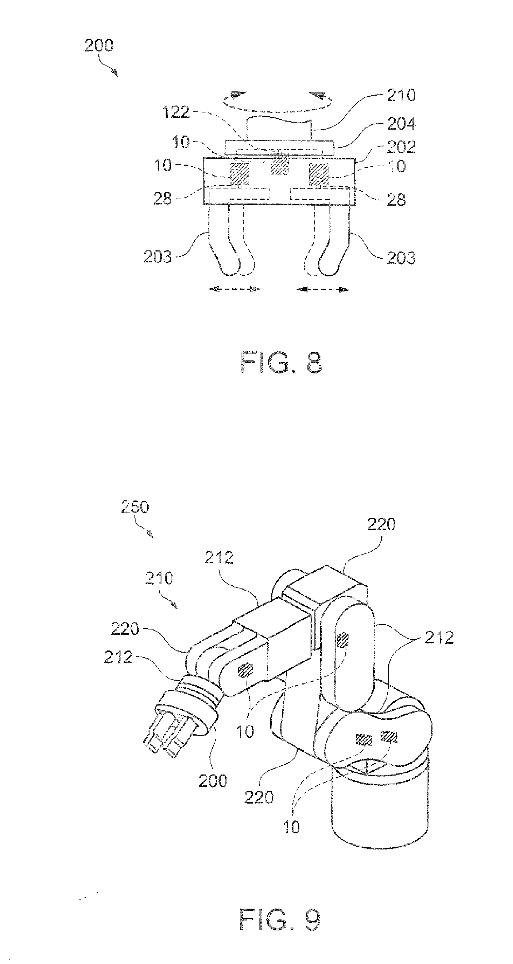

Fig. 8 is an explanatory drawing illustrating a robot hand 200 having the piezoelectric motor 10 of the second embodiment integrated therein. The illustrated robot hand 200 (hand portion) includes a plurality of finger portions 203 extending upright from a base 202, and is connected to an arm 210 via a wrist 204. Here, base portions of the finger portions 203 are movable within the base 202, and the piezoelectric motors 10 are mounted in a state in which the projecting portions 28 are pressed against the base portions of the finger portions 203. Therefore, by operating the piezoelectric motors 10, the finger portions 203 may be moved to grip an obj ect. The piezoelectric motors 10 correspond to "drive units" to change the distances between the plurality of finger portions 203. The piezoelectric motor 10 is mounted in a state in which the projecting portion 28 is pressed against an end surface of the wrist 204. Therefore, by driving the piezoelectric motor 10, the entire part of the base 202 may be rotated.

### Fourth Embodiment

Fig. 9 is an explanatory drawing illustrating a single-arm robot 250 having the robot hand 200 (hand portion). As illustrated, the robot 250 includes a plurality of link portions 212 (link members) and the arm 210 (arm portion) having joint portions 220 connecting the link portions 212 so as to allow bending thereof. The robot hand 200 is connected to a distal end of the arm 210. The joint portions 220 each include the piezoelectric motor 10 integrated therein as a drive unit for bending the joint portions 220. Therefore, by operating the piezoelectric motor 10, the respective joint portions 220 may be bent to given angles.

### Fifth Embodiment

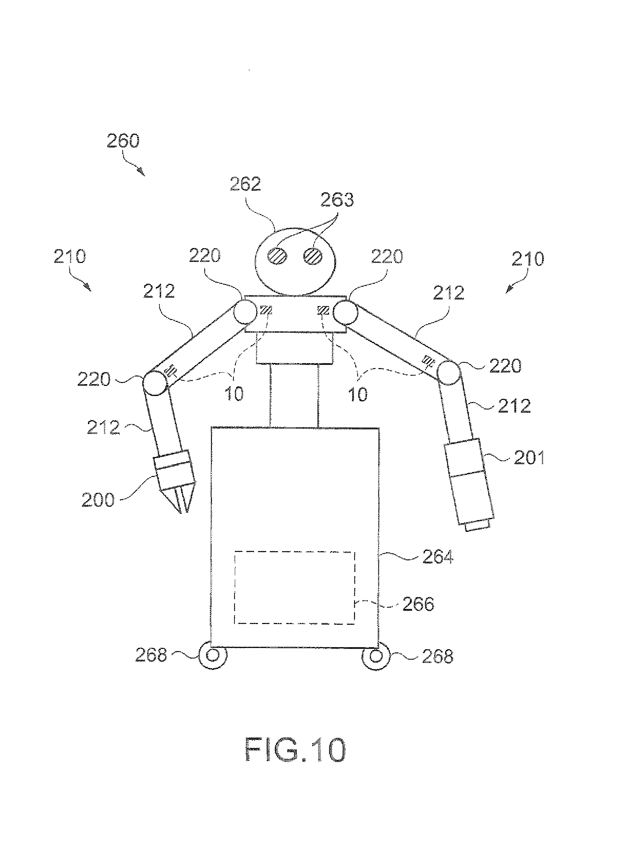

Fig. 10 is an explanatory drawing illustrating a plural-arm robot 260 having the robot hand 200. As illustrated, the robot 260 includes the plurality of link portions 212 and a plurality (two in the illustrated example) of the arms 210 having the joint portions 220 connecting the link portions 212 so as to allow bending thereof. The robot hands 200 and a tool 201 (hand portion) are connected to the distal end of the arm 210. A plurality of cameras 263 are mounted on a head portion 262, and a control portion 266 configured to control the entire operation is mounted in the interior of a body portion 264. In addition, the robot 260 is configured to allow a transfer by using casters 268 provided on a bottom surface of the body portion 264. The robot 260 also has the piezoelectric motors 10 as drive units integrated in the joint portions 220 for bending the joint portions 220. Therefore, by driving the piezoelectric motor 10, the respective joint portions 220 may be bent to given angles.

## Claims

1. A piezoelectric motor (10) comprising:
a piezoelectric element (20) including a first main surface (20a) and a second main surface (20b) configured to vibrate when a bending vibration mode is excited or vibrate when the bending vibration mode and a vertical vibration mode are excited;
a first main surface supporting member (30, 31) configured to come into surface contact with supporting portions (S1, S2, S3, S4) arranged separately in four corner directions of the first main surface (20a) of the piezoelectric element (20);
a holding member (40, 41) configured to come into surface contact with a surface facing the first main surface of the first main surface supporting member (30, 31);
a second main surface supporting member (32, 33) arranged at a position surface-symmetrical with respect to the first main surface supporting member (30, 31) with the piezoelectric element (20) interposed therebetween and configured to come into surface contact with the second main surface (20b) of the piezoelectric element (20); and
a machine casing member (70) configured to come into surface contact with a surface of the second main surface supporting member (32, 33) opposite from the contact surface with respect to the piezoelectric element (20), wherein
the machine casing member (70), the second main surface supporting member (32, 33), the piezoelectric element (20), the first main surface supporting member (30, 31), and the holding member (40, 41) are stacked in this order, the contact surfaces of the piezoelectric element (20) and the first main surface supporting member (30, 31) and the contact surfaces of the piezoelectric element (20) and the second main surface supporting member (32, 33) are joined by a joint material, and the contact surfaces of the first main surface supporting member (30, 31) and the second main surface supporting member (32, 33) are formed with irregularities (T).

2. The piezoelectric motor (10) according to Claim 1, wherein the contact surfaces of the piezoelectric element (20) are also formed with the irregularities (T).

3. A robot hand (200) configured to grip an object by using a plurality of finger portions (203) comprising:
a base (202) provided with the plurality of finger portions (203) extending upright so as to be movable; and
a drive unit configured to change distances between the plurality of finger portions (203) by being provided on the base (202) and driving proximal ends of the finger portions (203), wherein
the drive unit corresponds to a piezoelectric motor (10) as claimed in claim 1 or 2.

4. A robot (250) comprising:
an arm portion (210) provided with a rotatable joint portion (220);
a hand portion (200) provided with the arm portion (210), and
a drive unit provided at the joint portion (220) and configured to bend or rotate the joint portion (220), wherein
the drive unit corresponds to a piezoelectric motor (10) as claimed in claim 1 or claim 2.

5. A piezoelectric motor (10) comprising:
a piezoelectric element (20) configured to make bending vibrations;
a first supporting member (30) and a second supporting member (31) arranged on one (20a) of the surfaces of the piezoelectric element (20) and configured to support the piezoelectric element (20); and
a third supporting member (32) and a fourth supporting member (33) arranged on the other one (20b) of the surfaces of the piezoelectric element (20) opposite from the one (20a) of the surfaces and configured to support the piezoelectric element (20), wherein
the one (20a) of the surfaces and the other one (20b) of the surfaces include a direction in which the piezoelectric element (20) makes the bending vibrations, and
the first supporting member (30), the second supporting member (31), the third supporting member (32), and the fourth supporting member (33) include irregularities (T) on contact portions that come into contact with the piezoelectric element (20).

6. The piezoelectric motor (10) according to Claim 5, wherein the third supporting member (32) is arranged so as to face the first supporting member (30) via the piezoelectric element (20), and the fourth supporting member (33) is arranged so as to face the second supporting member (31) via the piezoelectric element (20).

7. The piezoelectric motor (10) according to Claim 5 or 6, wherein the one (20a) of the surfaces and the other one (20b) of the surfaces of the piezoelectric element (20) include irregularities (T).

8. The piezoelectric motor (10) according to any one of Claims 5 to 7, wherein excitation electrodes arranged on the one (20a) of the surfaces and the other one (20b) of the surfaces of the piezoelectric element (20) include irregularities (T).

9. The piezoelectric motor (10) according to any one of Claims 5 to 8, wherein the irregularities (T) have a cross section in the direction in which the piezoelectric element (20) comes into abutment with a driven member (90).

10. The piezoelectric motor (10) according to any one of Claims 5 to 9, comprising:
a holding member (40, 41) configured to hold the first supporting member (30) and the second supporting member (31) from the one (20a) of the surfaces;
a machine casing member (70) configured to hold the third supporting member (32) and the fourth supporting member (33) from the other one (20b) of the surfaces; and
a resilient member (60, 61) configured to come into contact with the holding member (40, 41) and press the holding member (40, 41) toward the piezoelectric element (20).

11. The piezoelectric motor (10) according to Claim 10, wherein the resilient member (60, 61) is a spring.

12. A robot hand (200) comprising:
a finger portion (203) configured to be openable and closable;
a base portion (202) provided with the finger portion (203); and
a piezoelectric motor (10) according to any one of claims 5 to 11, provided on the base portion (202) and configured for opening and closing the finger portion (203).

13. A robot (250) comprising;
an arm portion (210) provided with a bendable joint portion (220); and
a piezoelectric motor (10) according to any one of claims 5 to 11, provided at the joint portion (220) and configured for bending the joint portion (220).
